Europäisches Patentamt

European Patent Office

Office européen des brevets

(11) Publication number: **0 031 716 B2**

# (12) NEW EUROPEAN PATENT SPECIFICATION

(45) Date of publication of the new patent specification: **02.01.91**

(21) Application number: **80304699.4**

(22) Date of filing: **23.12.80**

(51) Int. Cl.⁵: **G 01 R 13/40,** G 01 R 13/02, G 01 D 7/00

(54) **Measuring instrument provided with analog and digital display.**

(30) Priority: **28.12.79 US 107766**

(43) Date of publication of application: **08.07.81 Bulletin 81/27**

(45) Publication of the grant of the patent: **11.09.85 Bulletin 85/37**

(45) Mention of the opposition decision: **02.01.91 Bulletin 91/01**

(84) Designated Contracting States: **CH DE FR GB IT LI SE**

(56) References cited:
**DE-B-1 623 873**
**GB-A-2 001 458**
**GB-A-2 002 550**
**US-A-4 081 953**

**K. Steinnbuch u.a. "Taschenbuch der Informatik", Springer-Verlag 1974, Vol. II, pp. 369, 370**

**"Funkschau" 1978, No. 10, p. 467**

(73) Proprietor: **Federal Products Corporation 1144 Eddy Street Providence Rhode Island 02901 (US)**

(72) Inventor: **Clark, Earl S. 13 Mohawk Street Coventry Rhode Island 02816 (US)**

(74) Representative: **Dr. Elisabeth Jung Dr. Jürgen Schirdewahn Dipl.-Ing. Claus Gernhardt P.O. Box 40 14 68 Clemensstrasse 30 D-8000 München 40 (DE)**

## Description

This invention relates to a measuring instrument and is concerned with an instrument providing a display both in the form of a quasi-analog scale and numerically (digitally).

There are in the prior art a number of devices which digitally indicate measurements as, for example, a micrometer of the kind disclosed in United States Patent Specification US—A—3,924,336 and height gauges as disclosed in United States Patent Specifications US—A—3,924,337 and US—A—4,037,325. United States Specification US—A—3,924,336 discloses a micrometer gauge of the conventional design in which a U-shaped frame supports an anvil at one end and a displaceable measuring element at the other that is movable toward or away from the anvil by a manually-rotatable thimble to contact a workpiece held between the anvil and measuring element. However, instead of the conventional mechanical readout, the measuring element carries the core of a differential transformer which produces an analog electrical signal representing the position of the measuring element. The measuring element and transformer thus provide an electromechanical transducer providing an electrical analog signal that is a function of the position of the measuring element. Circuitry is provided to convert this analog signal to a digital form signal and the digital form signal is applied through a decoder to activate a liquid crystal digital display having a plurality of numeric indicators. In this way the position of the micrometer measuring element is displayed digitally.

The micrometer type of gauge is intended to provide a measurement or a series of measurements of a part in which each digital value is read upon the user being satisfied that the part is properly clamped between the anvil and the end of the measuring element. At this stage the digital display is stationary and may be read.

A special problem arises where a gauge is used in measuring the dimensions of a part that is moving with respect to the gauge's measuring element, for example where the element is following a surface contour of a part being rotated with respect to the gauge. Such action may be taken when looking for maxima or minima in dimensions when checking the tolerance of the part.

Gauges whose output is displayed digitally are unsatisfactory when a part being measured is moving with respect to the gauge so that the decimal numerals are changing too rapidly to be followed by the eye. This forces the operator to slow the machinery down to a point where he can make a visual indication with some accuracy and/or see the measurement variation that is occurring.

The present invention enables us to provide a display device for a measuring instrument in which a value is displayed on a quasi-analog scale simultaneously with its display in digital form to a higher degree of accuracy whereby the analog scale is interpolated. The analog scale enables variations to be better seen by the operator; the digital display enables values to be read out with accuracy. The analog scale and numerical display are linked in a particular manner that is explained hereinafter. Both the quasi-analog and digital portions of the display utilised in the present invention employ liquid crystal display technology. Such technology is of itself known. Examples are found in the electronic watch displays mentioned below.

The provision of visible displays simultaneously in both analog and digital form are known. For example, there are various prior proposed time pieces that display time in a combination of quasi-analog and digital displays. Such displays are disclosed in United States Patents US—A—3,772,874 and US—A—4,081,953 and in British Patent Specification GB—A—2,002,550. Another example of a dual display is found in United States Patent US—A—3,696,385 which discloses a digital read-out of values corresponding to those on a conventional rotatable mechanical scale. United States Patent US—A—3,619,574 also discloses a combined display in a counter-type of instrument — which in this respect is similar to electronic timepieces discussed below — which uses a course analog display operative on the highest order digit and over-range to provide a general indication to an operator of the coarse range in which the instrument is operating but not to provide usable measurement information.

Timepieces do not face the same problems in design that are found in measuring instruments. They are inherently self-contained, the electronic digital timepiece having an internal clock oscillator and various counter/decoder circuits all driven from the clock source to activate a steadily incrementing display of time. Some displays for example show the hours digitally and the minutes, and possibly also seconds, on a quasi-analog display such as U.S. Patents US—A—4,081,953 and US—A—3,772,874. Others such as British Specification GB—A—2,002,550 prefer to show the hours quasi-analog style and the minutes and seconds numerically. This latter specification does in fact coarsely sub-divide the hours to give a better analog impression of the passage of time. The sub-divisions do not themselves correspond with any particular order digit of the numerical display.

DE—B—1 623 874 discloses an instrument for displaying measured values converted to digital signals in form of a luminous band consisting of a plurality of energizable luminous cells. The luminous band can be provided on a viewable display face in circular shape and a digital display may be disposed in the free central area of the viewable display face. The luminous band and the digital display may indicate the same measured value.

As indicated above a measuring instrument has to meet requirements that have no counterpart in timepieces. An unknown value is to be measured and displayed and the value may increase or decrease. As indicated above changes in the input value may be too rapid for their significance to be appreciated by the human eye when viewing a purely digital read-out. There is an advantage in using an analog scale which provides a better appreciation of the nature of changes while also providing a digital display to give a higher read-out accuracy when required.

The present invention enables us to provide a measuring instrument in which the analog scale calibration is directly linked to the digital display but above the level of the least significant digit which changes the most rapidly. More particularly the analog scale provides usable and readily appreciated measurement information in the course of making a measurement that is reflected in the digital display but the latter provides a finer measurement resolution.

According to the present invention there is provided a measuring instrument comprising an electromechanical input transducer having a movable measuring element extending therefrom to contact a workpiece and providing an electrical analog signal representing the position of the measuring element, a digital display comprising at least three numeric indicators supported on a viewable display face, each numeric indicator comprising a multi-segment liquid crystal display, means for converting said analog signal to a digital form signal, and decoder means responsive to said digital form signal and connected to said digital display to activate the numeric indicators in accord with said digital form signal, said decoder means comprising a decoder/driver means connected to selectively activate said numeric indicators in response to the digital form signal in accord with the value of the analog signal, characterized by

an analog display comprising an arry of liquid crystal display segments supported on said viewable display face in form of a scale providing a stepped analog display,

said decoder means comprising a further decoder/driver means connected to selectively activate said array in response to the digital form signal so as to activate a segment of said scale in accord with the value of the analog signal,

the operation of said decoder/driver means being related with respect to the values displayed such that an increment of one segment of the array scale equates to a unit change of number in the second least significant digit of the numeric display whereby the second and third least significant digits together display numbers corresponding to the number indicative activated segment of the analog scale, and the least significant digit provides an interpolation of values lying between adjacent scale segments,

a further display segment set in said face, and comparator means connected to activate said further segment and responsive to said digital form signal to cause said further segment to display when a preset limit is equalled or exceeded, and

means for supporting a workpiece to be measured, means supporting said transducer for the measuring element thereof to contact the workpiece, said workpiece supporting means allowing movement of a workpiece supported thereby relative to said measuring element such that the measuring element follows variations in a peripheral dimension of said workpiece whereby such variations are displayed.

The analog scale may be of the kind where one segment is activated at a time to display the appropriate value or of the bar graph type where a series of segments are activated, the number indicative segment being the last of the series.

It will be seen that in the measuring instrument of the invention the incrementing of the analog display, which is itself a stepped display, is directly related to the incrementing of the second least significant digit of the numeric (digital) display. In effect they display the same information. Still more particularly the second and third least significant digits together display the same information as indicated on the analog display.

In one embodiment of the invention the analog scale has one hundred (100) segments arranged in a circle to give one hundred (100) steps in one traversal of the scale. This corresponds to the range of one hundred (100) of the second and third least significant digits, assuming these are of the conventional decimal display type. The numeric display is conveniently located within the analog scale circle.

The analog scale may be arranged in the form of a "zero" reference segment with scale segments extending to each side thereof to represent relatively plus and minus values, the digital display further having polarity-indicative display segments set in the viewable display face and activatable to indicate a positive or negative value for a number displayed on the digital display.

For gauging workpieces for example, the instrument may further comprise a housing from which the measuring element projects and which carries the viewable display face, the housing also having means adjustably attaching it to a support extending from a base, which in some cases may itself be used for locating a workpiece to be measured, so that the position of the instrument measuring element referred to the base is adjustable.

A measuring instrument as set forth above may be provided with a further display segment set in the viewable face, and comparator means connected to activate the further segment and responsive to the digital form signal to cause the further segment to display when a preset limit is equalled or exceeded. More particularly this arrangement can be duplicated to detect and display signal excursions beyond defined upper and lower limits. This finds particular utility in checking whether an input value being measured is within set tolerances.

For convenience in use, additional display segments may be provided such as a low battery indicator segment or segments. Through the use of the electronic circuitry associated with the device, the least significant digit in the digital display serves as a vernier in interpolating between analog segments.

The invention finds particular utility in measuring a part which is moving. To this end an instrument embodying the invention may comprise means for supporting a workpiece to be measured, means for supporting a workpiece to be measured, means for supporting the transducer for the measuring element to contact the workpiece, the workpiece supporting means allowing movement of a workpiece supported thereby relative to the measuring element such that the latter follows variations in a peripheral dimension of the workpiece, whereby such variations are displayed.

The invention and its practice will be further described in relation to a measuring gauge instrument embodying the invention and illustrated in the accompanying drawings, in which:

Figure 1 is a perspective view illustrating the measuring gauge instrument in one practical application;

Figure 2 is a perspective view illustrating the instrument in another application;

Figure 3 is an enlarged, more detailed, view of the display face of the instrument;

Figure 4 is a block schematic diagram of the circuitry of the display device whose face is seen in Figure 3; and

Figure 5 is a block diagram illustrating an alternative transducer for the circuit of Figure 3.

For the purposes of illustration, the invention is shown embodied in measurement systems for machine parts.

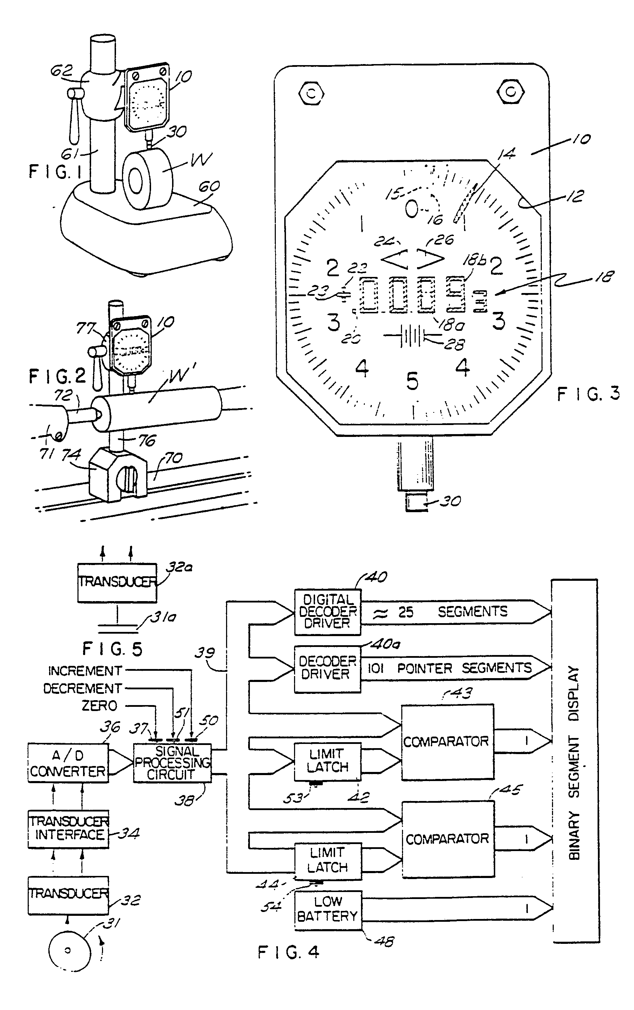

In the system of Figure 1 there is illustrated a gauging station which is known, for example, as a comparator and which includes a ground base 60 with a vertical column 61 rising from the base. On the column 61 is a mounting attachment 62 to which the case 10 of the measuring instrument is attached. As will be seen by referring to the drawing, the instrument has a displaceable measuring stem 30 that is engaging a workpiece W which lies on the ground base 60 and may be rolled thereon to give a measurement as the measuring stem 30 engages the periphery thereof.

In the system of Figure 2 a gauging station is shown in use on a rotating part on a lathe or a similar machine which includes a bed 70. As is usual in a rotating tool machine there is rising from the bed a fixture such as 71 that carries a center point such as 72 or the like, a chuck (not shown) being used to drive the rotating machine part here illustrated as W'. On the bed 70 there is mounted a base 74 which may be of the permanent magnet type that carries an upright post 76 and like the illustration in Figure 1 there is an attachment member 77 which carries the instrument case 10.

Referring now to Figure 3 contained within the case 10 of the instrument is electronic circuitry as well as display segments selectively driven by the circuitry and which are supported on a display face of a suitable material such as glass or the like as well known to those skilled in the art. The display face which is viewable through a window 12 of the case comprises an array of, for example, one hundred segments circularly arranged in a scale to indicate dial divisions. For ease in illustration one segment 14 is shown in the visible state while two segments 15 and 16 are shown in broken lines to indicate non-illuminated or non-visible segments. It will be of course understood as well known to those skilled in the art that each of the segments is connected to an electrical lead so that it may be appropriately energized by electronic driver circuitry. Representative scale indicia are provided for the array segments which may indicate some form of measurement either in thousandths of an inch, tenths of an inch, appropriate metric system units, volts, millivolts, milliamps, grams, or whatever units corresponding to the variable being measured, and accordingly suitable digits and scale divisions as seen in Figure 3 are provided. It will be seen from the Figure that the scale segments 14—16 and so on are formed as pointers to the marked scale indicia. Thus measurements indicated on this scale are incremental or stepped without any interpolation between next adjacent segments. This is what has been called above a quasi-analog display and may also be referred to in the illustrated form as a pointer-type display. The segments could be alternatively all activated up to the value to be indicated in the manner of a bar graph. Various scale layouts are possible.

Within the central area of the circularly arranged segments there is provided a multi-digit numerical display comprising a line of digit indicators each comprising groups of segments selectively operable to display a required number as, for example, seven individual segments for each digit position. There are illustrated and generally indicated at 18 five such digital display areas, two of which are indicated as 18a and 18b. In addition, there are provided at least three decimal point segments as, for example, the decimal point indicated by the reference numeral 20 and two further sets of segments 22 and 23 which will indicate a direction or polarity in the form of a plus or a minus as the case might be.

For certain purposes, it is desirable to provide means which will indicate when a part is within a given tolerance. It is appropriate to be able to put into and store in the instrument an upper limit of measurement as well as a lower limit of measurement and when these are reached or exceeded, annunciator segments such as segments 24 and 26 can be illuminated. Additionally, since the illustrated instrument is of a portable nature, it is battery powered and segments such as 28 are provided to display the symbol of a battery indicating to the user that the battery needs to be replaced. It will be understood, of course, that the segments and the input leads thereto may be formed on the suitable support layer by a variety of methods such as sputtering, evaporation, photo masking or etching and the segments may be made of a suitable transparent electrically-conductive reflective or transparent material depending upon whether the display is operated in a reflective or transmissive mode, all as well known to those skilled in the visible binary segment display art. Specifically the display uses liquid crystal display (LCD) segments to form both the numerical display and the analog scale. The scale segments are individual LCD elements. Each digit position is a multi-segment LCD display selectively operable to show numbers.

The display shown in Figure 3, which is a combination analog display and a digital display, has been particularly structured to provide a display for a distance measuring device, which is generally known in the art as a dial indicator. Dial indicators have long been known in the measuring art and are exemplified as, for example, by U.S. Patent 2,484,770. Basically, they have been used to ascertain the value of a variation from a standard or they might be used to measure the eccentricity of a rotating part, such as a part which is being trued in a lathe. The analog display is necessary to search for high and low points in such a situation. These prior art devices are mechanical devices in which magnification is obtained with gears and accuracy is necessarily limited and is a direct result of tolerance in the mechanical parts. By using an electrical method, there is only one moving part and there is no gear nor bearing wear resulting in error as in the prior devices. Further, the resistance to shock is excellent.

Accordingly, the present instrument utilizes an input transducer, and in the mechanical distance measuring version has the measuring stem 30 which is coupled directly to the transducer. Referring now to Figure 4, there is shown a part 31 which is being measured for tolerance or eccentricity for example as mentioned above. The part is contacted by the displaceable measuring stem 30 (Figure 3) whose movement is communicated to a transducer 32. The transducer 32 may take a variety of forms but it is preferred to utilize a differential transformer which is well known in the art as consisting of a primary coil, a pair of secondary coils and a core member which is carried by the movable member or measuring stem 30. The primary coil of a differential transformer system is, as well known to those skilled in the art, energized by an oscillator which energizes the primary coil at a frequency say of 5 kHz. The outputs of the secondary coils develop a differential voltage or other analog signal such as a variable inductance that varies as a function of the position of the core member relative to the secondary coils, and this analog signal is then passed through a suitable amplifying transducer interface 34 and thence to an analog-to-digital converter 36 which, for example, could be a type LD131 made by Siliconix. This converter generates signals in a coded form representative of the instantaneous amplitude or frequency of the analog signal being evaluated. The signals are then provided to an electronic circuit 38 consisting of logic gates interconnected in a certain prescribed manner enabling their use for carrying out such operations as digital signal comparison, counting, bit incrementing and decrementing and signal power amplification. The circuit 38 can be realised with the aid of a microprocessor device programmed to perform the functions stated. The circuitry is also designated to accept inputs from switches manually actuated to alter the circuits function. An additional function of the circuit is to provide electrical signal outputs to external computers, signal processors, process control systems, statistical analyzers and the like. The signal processing circuit 38 may include a memory location which will be loaded with the contents of a bus 39 when the zero switch 37 is activated. This number will be subtracted from future readings. An increment switch 50 will cause this stored number to increase at the rate of approximately three numbers per second as long as the switch is held closed. A decrement switch 51 will cause this stored number to decrease at the rate of approximately three numbers per second as long as the switch is held closed.

The bus 39 provides communication between the circuit 38 and a number of other circuits comprising decoder/driver 40, a decoder/driver 40a, a limit one latch 42, a limit two latch 44, and also a comparator 43 and a comparator 45. Decoder/driver 40 provides sufficient voltage for driving the segments of the digit indicators of the digital display 18 and is responsive to a binary coded input from bus 39. Decoder/driver 40a is also responsive to a binary-coded input, which may be the same input as for unit 40, from bus 39 and will drive up to 101 segments of the so-called pointer display as seen generally in Figure 3. The operational relationship between the decoder/drivers is such that in the decoder/driver 40a for the scale segments steps the indication one segment for each unit change in the decimal numerical value of the next to least significant digit 18b of the numerical display. Thus, whenever the digit 18b changes effectively it will be accompanied by an incrementing or decrementing of the analog scale by one causing a different position to illuminate adjacent to the previously illuminated position. For example, by referring to the drawing, if the digit 18b increments by "one" and assuming that 15 was illuminated, then 16 will become illuminated at the time of the increment. The decoder/driver 40, however, is working to a finer degree of resolution in driving the fifth, least significant digit of the display and thereby provides an interpolation of the analog display scale or, for example, a grad splitter. As seen in Figure 3 by way of example, it will be noticed that the analog display shows by illuminated position 14 the digit 9, while the digital display shows 0.00093, the last digit being effectively the fifth decimal digit represented on bus 39 to which the decoder/driver 40 is responsive, and of course, indicates that the actual position as seen by the transducer 32 is three-tenths of the way between 9 and 10.

Limit latch 42 is used to store a reading by pressing button 53, and it can be readily seen by referring to the drawing that the reading is stored in latch 42 and is compared with the reading currently found on the bus 39 by the comparator 43. The comparator will energise an annunciator such as 24 as seen in Figure 3 on the display to indicate when the bus value equals or exceeds in one direction the limit stored in latch 42. A similar operation occurs for limit latch 44 on the drawings, and this can store a different reading in an opposite direction by pressing button 54, and when its comparator 45 senses the equalling or exceeding in the opposite direction of that reading, then it will pulse the other annunciator 26. Thus excursion beyond set high and low limits are indicated.

For convenience of operation a low battery sensor 48 may be provided which will be sensitive to the battery voltage, and if the battery voltage drops below a preset level will pulse the display segments 28 and shut down the rest of the system.

Referring to Figure 5 an alternate transducer 32a is illustrated as coupled to electric lines 31a, the transducer 32a being sensitive, for example, to voltage current or resistance or any other electrical parameter desired. For example, one can conceive of a situation in which the electrical transducer 32a could also be sensitive to pressure, could indicate force in the form of a strain gauge or temperature, and divers other applications. In this embodiment, the disadvantages of the slow response of usual analog meters, due in large measure to the ballistics of the movement, are avoided and, for example, the tuning of resonant circuits may be easily facilitated.

**Claims**

1. A measuring instrument comprising an electromechanical input transducer having a movable measuring element (30) extending therefrom to contact a workpiece (31) and providing an electrical analog signal representing the position of the measuring element, a digital display comprising at least three numeric indicators (18) supported on a viewable display face, each numeric indicator comprising a multi-segment liquid crystal display (18a, 18b), means (36) for converting said analog signal to digital form signal, and decoder means (40, 40a) responsive to said digital form signal and connected to said digital display to activate the numeric indicators in accord with said digital form signal, said decoder means comprising a decoder/driver means (40a) connected to selectively activate said numeric indicators in response to the digital form signal in accord with the value of the analog signal, characterized by

an analog display comprising an array of liquid crystal display segments (14—16) supported on said viewable display face in form of a scale providing a stepped analog display,

said decoder means comprising a further decoder/driver means (40) connected to selectively activate said array in response to the digital form signal so as to activate a segment of said scale in accord with the value of the analog signal,

the operation of said decoder/driver means (40, 40a) being related with respect to the values displayed such that an increment of one segment of the array scale (14—16) equates to a unit change of number in the second least significant digit (18b) of the numeric display (18) whereby the second (18b) and third (18a) least significant digits together display numbers corresponding to the number indicative activated segment of the analog scale, and the least significant digit provides an interpolation of values lying between adjacent scale segments,

a further display segment (24 or 26) set in said face, and comparator means (43 or 45) connected to activate said further segment (24 or 26) and responsive to said digital form signal to cause said further segment to display when a preset limit (42 or 44) is equalled or exceeded, and

means (60, 71, 72) for supporting a workpiece to be measured, means (61, 62; 70, 74, 76, 77) supporting said transducer for the measuring element thereof to contact the workpiece, said workpiece supporting means allowing movement of a workpiece supported thereby relative to said measuring element such that the measuring element follows variations in a peripheral dimension of said workpiece whereby such variations are displayed.

2. A measuring instrument as claimed in claim 1, characterized by said analog scale comprising a "zero" reference segment with scale segments extending to each side thereof to represent relatively plus and minus values; and by said digital display further having polarity-indicative display segments (22, 23) set in said face and activatable to indicate a positive or negative value for a number displayed on said digital display.

3. A measuring instrument as claimed in any preceding claim further characterized by a housing (10) from which said measuring element (30) projects and which carries said viewable display face, said housing having means (62, 77) adjustably attaching it to a support (61, 76) extending from a base (60, 70) so that the position of the instrument measuring element (30) referred to the base (60, 74) is adjustable.

4. A measuring instrument as claimed in any preceding claim further characterised by a housing (10) from which said measuring element (30) projects and which carries said viewable display face, said housing having means (62, 77) adjustably attaching it to a support (61, 76) extending from a base (60, 74) so that the position of the instrument measuring element (30) referred to the base (60, 74) is adjustable.

5. A measuring instrument as claimed in any one of Claims 1 to 3 further comprising means (60; 70—74) for supporting a workpiece to be measured, means (61, 62; 76, 77) supporting said transducer for the measuring element thereof to contact the workpiece, said workpiece supporting means allowing movement of a workpiece supported thereby relative to said measuring element such that the measuring element follows variations in a peripheral dimension of said workpiece whereby such variations are displayed.

**Patentansprüche**

1. Meßgerät, umfassend einen elektromechanischen Eingangswandler, von dem sich ein bewegliches Meßelement (30) zum Kontaktieren eines Werkstücks (31) erstreckt, und der ein die Meßelementposition darstellendes elektrisches Analogsignal liefert, eine Digitalanzeige, umfassend wenigstens drei numerische Anzeiger (18), die an einer sichtbaren Anzeigefläche getragen sind, wobei jeder numerische Anzeiger eine Mehrsegment-Flüssigkristallanzeige (18a, 18b), Mittel (36) zum Umsetzen des besagten Analogsignals in ein Signal digitaler Form und eine Dekodiereinrichtung (40, 40a) umfaßt, die auf das Signal digitaler Form anspricht und mit der digitalen Anzeige verbunden ist, um die numerischen Anzeiger in Übereinstimmung mit dem Signal digitaler Form zu aktivieren, wobei die Dekodiereinrichtung Dekodier-/Treibermittel (40a) aufweist, die angeschlossen sind, um die numerischen Anzeiger beim Ansprechen auf das Signal digitaler Form in Übereinstimmung mit dem Wert des Analogsignals wahlweise zu aktivieren, gekennzeichnet durch

eine Analoganzeige, die eine Anordnung von Flüssigkristallanzeigesegmenten (14—16) aufweist, die an der sichtbaren Anzeigefläche in Form einer Skala getragen sind, welche eine gestufte Analoganzeige schafft, wobei

die Dekodiereinrichtung weitere Dekodier-/Treibermittel (40) aufweist, die angeschlossen sind, um die Anordnung beim Ansprechen auf das Signal digitaler Form derart wahlweise zu aktivieren, daß ein Segment der Skala in Übereinstimmung mit dem Wert des Analogsignals aktiviert wird, und

das Arbeiten oder Dekodier-/Treibermittel (40, 40a) mit Bezug auf die angezeigten Werte so im Zusammenhang steht, daß ein Inkrement eines Segmentes der Anordnungsskala (14—16) einer Zahlenveränderungseinheit an der zweitniedrigsten Stelle (18b) der numerischen Anzeige (18) gleich ist, wodurch die zweit-(18b) und dritt-(18a) niedrigsten Stellen zusammen Zahlen anzeigen, die dem zahlenanzeigenden aktivierten Segment der Analogskala entsprechen, und die niedrigstwertige Stelle eine Interpolation von zwischen benachbarten Skalensegmenten liegenden Werten bildet,

ein weiteres Anzeigesegment (24 oder 26), welches in die besagte Fläche eingesetzt ist, und Vergleichermittel (43 oder 45), die angeschlossen sind zum Betätigen des weiteren Segmentes (24, oder 26) und auf das Signal digitaler Form ansprechen, um zu bewirken, daß das weitere Segment anzeigt, wenn ein voreingestellter Grenzwert (42 oder 44) erreicht oder überschritten wird, und

eine Einrichtung (60, 71, 72) zum Abstützen eines zu messenden Werkstücks, und eine Einrichtung (61, 62; 70, 74, 76, 77), die den Wandler abstützt, damit dessen Meßelement des Werkstück kontaktiert, wobei die Werkstückabstützeinrichtung Bewegung eines durch sie Abgestützten Werkstücks relativ zu dem Meßelement ermöglicht derart, daß das Meßelement Variationen einer Umfangsabmessung des Werkstücks folgt, wodurch solche Variationen angezeigt werden.

2. Meßgerät nach Anspruch 1, dadurch gekennzeichnet, daß die Analogskala ein "Null"-Bezugselement umfaßt, wobei sich beidseitig desselben erstreckende Skalensegmente relative Plus- und Minuswerte darstellen; und daß die Digitalanzeige weiterhin Polarität anzeigende Anzeigesegmente (22, 23) umfaßt, die in die besagte Fläche eingesetzt sind und zum Anzeigen eines positiven oder negativen Wertes für eine auf der Digitalanzeige angezeigte Zahl aktivierbar sind.

3. Meßgerät nach einem der vorhergehenden Ansprüche, weiter gekennzeichnet durch ein Gehäuse (10), von welchem, das Meßelement (30) vorragt und welches die sichtbare Anzeigefläche trägt, wobei das Gehäuse Mittel (62, 77) hat, die es an einer sich von einem Sockel (60, 70, 74) erstreckenden Stütze (61, 76) verstellbar anbringen, so daß die Position des Meßelementes (30) des Meßgerätes mit Bezug auf den Sockel (60, 74) verstellbar ist.

4. Messgerät nach einem der vorhergehenden Ansprüche, weiterhin gekennzeichnet durch ein Gehäuse (10), aus dem das besagte Messelement (30) herausragt, und das die besagte betrachtbare Anzeigefläche trägt, wobei das besagte Gehäuse mit Mitteln (62, 77) ausgestattet ist, die es verstellbar an einer sich von einem Sockel (60, 74) erstreckenden Stütze (61, 76) befestigen, so dass die Position des Messelements (30) des Instruments in Bezug auf den Sockel (60, 74) verstellbar ist.

5. Messgerät nach einem der Ansprüche 1 bis 3, weiterhin gekennzeichnet durch Mittel (60; 70—74) zum Tragen eines zu messenden Werkstücks, den besagten Wandler tragende Mittel (61, 62; 76, 77), damit dessen Messelement das Werkstück kontaktiert, wobei das besagte das Werkstück tragende Mittel die Bewegung eines damit getragenen Werkstücks relativ zum besagten Messelement gestattet, derart, dass das Messelement gestattet, derart, dass das Messelement Abweichungen in einer Umfangsdimension des besagten Werkstücks verfolgt, wodurch derartige Abweichungen angezeigt werden.

**Revendications**

1. Instrument de mesure comprenant un transducteur d'entrée électromécanique comportant un élément de mesure mobile (30) s'étendant à partir de ce transducteur afin d'entrer en contact avec un ouvrage (31) et produisant un signal

analogique électrique représentant la position de l'élément de mesure, un dispositif d'affichage numérique qui comprend au moins trois indicateurs numériques (18) montés sur un cadran d'affichage observable, chaque indicateur numérique comprenant un affichage à cristeaux liquides à plusieurs segments (18a, 18b), un dispositif (36) pour convertir le signal analogique en un signal de forme numérique, et un dispositif décodeur (40, 40a) réagissant au signal de forme numérique et connecté au dispositif d'affichage numérique pour activer les indicateurs numériques en fonction du signal de forme numérique, ledit décodeur comprenant un dispositif de décodage/de commande (40a) connecté pour activer sélectivement les indicateurs numériques en réaction au signal de forme numérique en fonction de la valeur du signal analogique, caractérisé par

un dispositif d'affichage analogique comprenant un ensemble de segments d'affichage à cristeaux liquides (14a, 16) monté sur ledit cadran d'affichage observable ayant la forme d'une échelle donnant un affichage analogique à progression pas à pas,

le dècodeur comprenant un autre dispositif de décodage/de commande (40) connecté pour activer sélectivement ledit ensemble en réaction au signal de forme numérique pour activer un segment de ladite échelle en fonction de le valeur du signal analogique,

le fonctionnement du dispositif de décodage/de commande (40, 40a) étant en rapport avec les valeurs affichées de sorte qu'un incrément d'un segment de l'échelle analogique (14 à 16) soit égal à une variation numérique unitaire du deuxième chiffre le moins significatif (18b) du dispositif d'affichage numérique (18), étant entendu que le deuxième (18b) chiffre et le troisième (18a) chiffre les moins significatifs forment ensemble des nombres affichés correspondant au segment activé de l'échelle analogique indicatif d'un nombre et le chiffre le moins significatif fournit une interpolation des valeurs comprises entre des segments adjacents de l'échelle,

un autre segment d'affichage (24 ou 26) encastré dans le cadran et un dispositif comparateur (43 ou 45) connecté pour activer cet autre segment (24 ou 26) et réagissant au signal de forme numérique pour amener cet autre segment à se manifester lorsqu'une limite préréglée (42 ou 44) est égalée ou dépassée, et

des moyens (60, 71, 72) pour supporter un ouvrage à mesurer et des moyens (61, 62; 70, 74, 76, 77) supportant le transducteur de manière que son élément de mesure vienne en contact avec l'ouvrage, les moyens de support de l'ouvrage permettant à un ouvrage ainsi supporté de se déplacer par rapport à l'élément de mesure de telle sorte que l'élément de mesure suive des variations d'un dimension périphérique de l'ouvrage et que ces variations soient affichées.

2. Instrument de mesure suivant la revendication 1, caractérisé en ce que l'échelle analogique comprend un segment de référence "zéro" de part et d'autre duquel s'étendent des segments d'échelle représentant des valeurs relativement positives et négatives et le dispositif d'affichage numérique comporte, en outre, des segments d'affichage indicateurs de polarité (22, 23) encastrés dans le cadran et pouvant être activés pour indiquer une valeur positive ou négative pour un nombre affiché sur le dispositif d'affichage numérique.

3. Instrument de mesure suivant l'une quelconque des revendications précédentes, caractérisé par un boîtier (10) à partir duquel l'élément de mesure (30) fait saillie et qui porte le cadran d'affichage observable, le boîtier comportant des moyens (62, 77) qui le fixent de facon réglable à un support (61, 76) s'étendant à partir d'une embase (60, 70, 74) de sorte que la position de l'élément de mesure (30) de l'instrument rapportée à la base (60, 74) soit réglable.

4. Instrument de mesure suivant l'une quelconque des revendications précédentes, caractérisé par un boîtier (10) à partir duquel l'élément de mesure (30) fait saillie et qui porte le cadran d'affichage observable, le boîtier comportant des moyens (62, 77) qui le fixent de façon réglable à un support (61, 76) s'étendant à partir d'une embase (60, 74) de sorte que la position de l'élément de mesure (30) de l'instrument rapportée à la base (60, 74) est réglable.

5. Instrument de mesure suivant l'une quelconque des revendications 1 à 3, comprenant en outre des moyens (60; 70—74) pour supporter un ouvrage à mesurer et des moyens (61, 62; 76, 77) supportant le transducteur de manière que son élément de mesure vienne en contact avec l'ouvrage, les moyens de support de l'ouvrage permettant à un ouvrage ainsi supporté de se déplacer par rapport à l'élément de mesure de telle sorte que l'élément de mesure suive des variations d'une dimension périphérique de l'ouvrage et que ces variations soient affichées.

F I G. 1

F I G. 2

F I G. 3

TRANSDUCER 32a

F I G. 5

INCREMENT
DECREMENT
ZERO

A / D CONVERTER 36

SIGNAL PROCESSING CIRCUIT 38

TRANSDUCER INTERFACE 34

TRANSDUCER 32

DIGITAL DECODER DRIVER 40 ≈ 25 SEGMENTS

DECODER DRIVER 40a 101 POINTER SEGMENTS

COMPARATOR 43

LIMIT LATCH 42

COMPARATOR 45

LIMIT LATCH 44

LOW BATTERY 48

BINARY SEGMENT DISPLAY

F I G. 4